# EUROPÄISCHE PATENTSCHRIFT

(11) **EP 4 193 430 B1**
(45) Veröffentlichungstag und Bekanntmachung des Hinweises auf die Patenterteilung: **26.02.2025**
(21) Anmeldenummer: 21755753.7
(22) Anmeldetag: 05.08.2021
(51) Int. Cl.: H01S 5/22

(54) **DIODENLASER MIT STROMBLENDE**
DIODE LASER HAVING A CURRENT SHIELD
LASER À DIODE DOTÉ D'UNE PROTECTION CONTRE LE COURANT

(30) Priorität: 05.08.2020 DE 102020120703
(43) Veröffentlichungstag der Anmeldung: 14.06.2023
(73) Patentinhaber: Ferdinand-Braun-Institut gGmbH, Leibniz-Institut für Höchstfrequenztechnik, 12489 Berlin (DE)
(72) Erfinder: DELLA CASA, Pietro, 12489 Berlin (DE); ELATTAR, Mohamed, 12489 Berlin (DE); CRUMP, Paul, 10245 Berlin (DE); WENZEL, Hans, 12355 Berlin (DE)
(74) Vertreter: Gulde & Partner
(86) Internationale Anmeldenummer: PCT/EP2021/071921
(87) Internationale Veröffentlichungsnummer: WO 2022/029254

(56) Entgegenhaltungen:
- WO-A2-2011/098797
- US-A- 5 144 633
- US-A- 5 987 048
- ELATTAR M ET AL: "High-brightness broad-area diode lasers with enhanced self-aligned lateral structure", SEMICONDUCTOR SCIENCE TECHNOLOGY, IOP PUBLISHING LTD, GB, vol. 35, no. 9, 27 July 2020 (2020-07-27), pages 95011, XP020356115, ISSN: 0268-1242, [retrieved on 20200727], DOI: 10.1088/1361-6641/AB9BEC

## Beschreibung

### Beschreibung

Die vorliegende Erfindung betrifft einen Diodenlaser mit einer Stromblende und insbesondere einen Diodenlaser mit einer angepassten "p-n-p" bzw. "n-p-n"-Struktur als Stromblende zur Reduzierung der Tunnelwahrscheinlichkeit.

### Stand der Technik

Breitstreifen-Diodenlaser (engl. "broad-area diode lasers", BALs) können eine besonders hohe Effizienz und Brillanz/Strahldichte aufweisen. In den zugehörigen Strukturen werden dabei stromblockierende Schichten, sog. Stromblenden, in die Randbereiche der Bauelemente integriert. Diesen sollen für einen Stromeinschluss unter dem Mittelstreifen sorgen, so dass die nachteiligen Auswirkungen auf die Strahlqualität durch eine Stromaufweitung und eine lateralen Ladungsträgerakkumulation (engl. "lateral carrier accumulation", LCA) begrenzt werden können. Außerdem lassen sich dadurch Verluste an den Streifenkanten minimieren, wodurch die Laserschwelle gesenkt und die Konversionseffizienz erhöht wird, während gleichzeitig eine hohe Polarisationsreinheit beibehalten werden kann. Die Reduzierung von Strom- und Ladungsträgerdichte an Streifenkanten führt zu einer geringeren Verstärkung für laterale Moden höherer Ordnung und kann somit sogar die Anzahl der geführten Moden reduzieren und dabei die Strahleigenschaften verbessern.

Eine Vielzahl lateraler Strukturierungstechniken wurden entwickelt, um den gewünschten zentralen Einschluss von Strom und Ladungsträgern insbesondere in GaAs-basierten BALs zu realisieren, wobei die Herausforderung darin besteht, die Strahlqualität zu verbessern, ohne Kompromisse bei *η*_{E}, maximalem *P*ₒₚₜ oder der Lebensdauer der Bauelemente einzugehen. Eine dieser Techniken ist die Hochenergie-Ionen-Implantation (engl. "highenergy deep ion implantation"), um einen Stromfluss in den Bauteilkanten zu verhindern. Implantationsprofile, insbesondere die die n-dotierte Seite des BALs erreichen, d. h. durch die aktive Zone hindurchgehen, eliminieren die Stromaufweitung in der p-Seite und unterdrücken die LCA aufgrund der schnellen Rekombination von Ladungsträgern, die an den durch die Implantation eingeführten Punktdefekten in die Gerätekanten diffundieren (M. Winterfeldt et al., IEEE Photonics Technol. Lett. 27, 1809-12 (2015); M. M. Karow et al., CLEO/Europe-EQEC, cb-5.4 (2019)). Eine andere Möglichkeit zur Blockierung des Stromflusses außerhalb des Laserstreifens ist eine gezielte O- und Si-Implantation in diesen Bereichen (D. Martin et al., Proc. SPIE 10900, 109000M (2019); P. Della Casa et al., Semicond. Sci. Technol. 34, 105005 (2019)). Die Stromblende wird hierbei in der p-seitigen Mantelschicht ausgebildet. Diese zwei Methoden können die Strahlqualität effektiv verbessern, jedoch mit einem Kompromiss bei *η*_{E} und geringe Wiederholbarkeit des Prozesses.

Stromblockierende Blendenstrukturen können auch durch die Integration einer hochdotierten n-Schicht in eine hochdotierte p-seitige (Sub-)Kontaktschicht eines Diodenlasers ("p-n-p"-Struktur) gebildet werden. Solche Struktur können insbesondere bei Hochleistungs-Breitstreifen-Diodenlasern vorteilhaft zur Blockierung des Stroms außerhalb des Laserstreifens eingesetzt werden (Y. Yamagata et al., Proc. SPIE 9348, 93480F (2015); M. Elattar et al., Semicond. Sci. Technol. 35, 095011 (2020), US5987048A) In ähnlicher Weise kann die n-dotierte Sperrschicht auch in andere Schichten der p-Seite eines Diodenlasers integriert werden, z. B. in die Mantelschicht. Die Sperrschicht kann auch p-dotiert und in die n-Seite des Lasers integriert sein, d. h. als "n-p-n"-Struktur ausgebildet werden. Allerdings weisen solche Stromblende-Strukturen aufgrund des Tunneleffekts durch die an jedem p-n-Übergang gebildete dünne Verarmungszone nur geringe Durchschlagsspannungen (engl. "punch-through voltage") auf. Das Auftreten von Tunnelströmen reduziert dabei die Wirksamkeit der Blockierung bei hohen Leistungen und Temperaturen.

### Offenbarung der Erfindung

Es ist daher eine Aufgabe der vorliegenden Erfindung, einen Diodenlaser mit einer Stromblende zur Verfügung zu stellen, bei dem die Tunnelwahrscheinlichkeit durch die Stromblende reduziert wird. Insbesondere soll die Wirksamkeit der Blockierung auch bei hohen Leistungen und Temperaturen erhalten bleiben.

Diese Aufgaben werden erfindungsgemäß durch die Merkmale des Patentanspruches 1 gelöst. Zweckmäßige Ausgestaltungen der Erfindung sind in den jeweiligen Unteransprüchen enthalten.

Ein beispielhafter Diodenlaser umfasst ein n-Substrat aus einem n-dotierten Material; eine auf dem n-Substrat angeordnete n-Mantelschicht aus einem n-dotierten Material; eine auf der n-Mantelschicht angeordnete n-Wellenleiterschicht aus einem n-dotierten Material; eine auf n-Wellenleiterschicht angeordnete aktive Schicht; eine auf der aktiven Schicht angeordnete p-Wellenleiterschicht aus einem p-dotierten Material; eine auf der p-Wellenleiterschicht angeordnete p-Mantelschicht aus einem p-dotierten Material; eine auf der p-Mantelschicht angeordnete p-Kontaktschicht aus einem p-dotierten Material; und einen auf der p-Kontaktschicht angeordneten p-Kontakt; wobei der Diodenlaser durch eine schichtförmig ausgebildete Stromblende aus einem entgegen seiner Umgebung dotierten Material für eine räumlich selektive Bestromung der aktiven Schicht zwischen dem n-Substrat und dem p-Kontakt ausgebildet ist; wobei die Stromblende über eine intrinsische Außenschicht (d. h. eine außenliegende Schicht aus einem intrinsischen Material) von angrenzenden Schichten getrennt ist, wobei die Dicke der intrinsischen Außenschicht zwischen 5 nm und 50 nm liegt. Die Stromblende kann entweder durch eine in die p-Seite des Lasers integrierte n-dotierte Schicht oder durch eine in die n-Seite integrierte p-dotierte Schicht realisiert werden.

Bei den Materialien der einzelnen Schichten handelt es sich insbesondere um Halbleitermaterialien. Als Kontaktschicht wird bei Diodenlasern im Allgemeinen eine effektiv zur Stromführung ausgelegte Schicht bezeichnet, welche jedoch nicht an der optischen Wellenführung teilnimmt. Die Kontaktschicht kann auch als Schichtenstapel ausgebildet sein. Insbesondere kann die Kontaktschicht eine Sub-Kontaktschicht und eine darauf angeordnete Kontaktierungsschicht umfassen. Typischerweise wird eine sehr hoch p-dotierte dünne Kontaktierungsschicht unter Verwendung von Standardmethoden selektiv implantiert, um die Streifen vor einer Metallisierung zu definieren (P. Della Casa et al., Semicond. Sci. Technol. 32, 065009 (2017)). Eine Stromblende, welche ebenfalls im Allgemeinen nicht an der optischen Wellenführung teilnehmen soll, hat demgegenüber die Aufgabe, einen Stromfluss durch die Blende effektiv zu unterdrücken bzw. zu blockieren. Durch die Anordnung der Stromblende kann somit der Stromfluss in der Laserdiode lokal eingegrenzt werden.

Die intrinsische Außenschicht kann dabei an der Oberseite oder der Unterseite der schichtförmig ausgebildeten Stromblende angeordnet sein, wobei ihre Wirkung an der Unterseite stärker ist. Vorzugsweise weist die Stromblende eine obere intrinsische Außenschicht und eine untere intrinsische Außenschicht auf. Bei einem intrinsischen (d. h. undotierten) Halbleitermaterial hängen die Ladungsträgerkonzentrationen im Leitungsband und im Valenzband im Wesentlichen nur von der Temperatur und von der Bandlücke ab. Im Gegensatz dazu wird bei dotierten Halbleitermaterialien deren Leitfähigkeit durch das gezielte Einbringen von Fremdatomen beeinflusst.

Der Betrag des vertikalen Abstands *d*ᵣₑₛ von der aktiven Zone zur Stromblende soll möglichst klein sein, bevorzugt kleiner als 1,5 µm, bevorzugter kleiner als 1 µm und noch bevorzugter kleiner als 0,5 µm, um eine minimale Stromverbreitung zu ermöglichen. Vorzugsweise ist die Stromblende innerhalb der p-Seite, beispielsweise in der p-Kontaktschicht angeordnet (positives *d*ᵣₑₛ, wobei eine p-seitige Strukturdicke typischerweise etwa 2 µm beträgt). Eine Anordnung innerhalb bedeutet dabei, dass die Stromblende von der p-Kontaktschicht nach oben und nach unten begrenzt wird. Im Gegensatz dazu kann eine Anordnung in der p-Kontaktschicht auch eine nur einseitige Begrenzung, d. h. nach oben oder nach unten, bedeuten. Die Stromblende kann jedoch entsprechend auch innerhalb der p-Mantelschicht oder der n-Seite des Lasers, beispielsweise in der n-Mantelschicht, angeordnet werden (negatives *d*ᵣₑₛ).

Vorzugsweise grenzt die Stromblende bei einer Anordnung innerhalb der p-Kontaktschicht nach oben und nach unten jeweils an eine Schicht aus p⁺-GaAs an. Es handelt sich hierbei im Wesentlichen um eine "p-n-p"-Struktur für die Stromblende, welche erfindungsgemäß durch mindestens eine intrinsische Außenschicht erweitert ist. Bei zwei intrinsischen Außenschichten wird die erfindungsgemäße Struktur als "p-i-n-i-p"-Struktur bezeichnet. Dies trifft auch bei einer Anordnung der Stromblende innerhalb der p-Mantelschicht zu. Ist die Stromblende jedoch in der n-Mantelschicht angeordnet, so wird durch die jeweils umgekehrte Dotierung der einzelnen Schichten eine entsprechende "n-i-p-i-n"-Struktur ausgebildet. Schichten aus anderen Materialien, welche an die Stromblende angrenzen können, umfassen p-AlGaAs (p-Mantelschicht), n-AlGaAs (n-Mantelschicht), und eine beliebige Kombination aus einem Al-In-Ga-As-P-Sb-N Materialsystem.

Erfinderungsgemäss umfasst die Stromblende eine erste Schicht aus dotiertem InGaP und eine auf der ersten Schicht aufliegende zweite Schicht aus dotiertem GaAs. Insbesondere kann die erste Schicht aus dotiertem In_{0.48}Ga_{0.52}P ausgebildet sein. Durch die Kombination zweier unterschiedlicher Sperrschichten in der Stromblende können die elektronischen Eigenschaften der Stromblende verbessert werden. Die Art der Dotierung (n oder p) der dotierten Schichten der Stromblende hängt dabei von der Anordnung der Stromblende in der Laserdiode ab. Auf der p-Seite sind die Schichten jeweils n-dotiert, während die Schichten auf der n-Seite jeweils p-dotiert sind.

Bei den genannten Ausführungsformen der Stromblende mit zwei Sperrschichten liegt das Verhältnis der Dicke der ersten Schicht zur Dicke der zweiten Schicht vorzugsweise zwischen 0,2 und 1,0. Ebenfalls bevorzugt ist, dass die Summe der Dicken der ersten Schicht und der zweiten Schicht zwischen 5 nm und 100 nm, bevorzugter zwischen 20 nm und 100 nm, bevorzugter zwischen 40 nm und 80 nm, und noch bevorzugter bei etwa 60 nm liegt. Vorzugsweise liegt die Dicke *d*ᵢ einer intrinsischen Außenschicht zwischen 5 nm und 50 nm, bevorzugter 15 nm und 30 nm, und noch bevorzugter bei etwa 20 nm. Bei einer Dicke von 20 nm kann die Tunnelstromdichte bei einer typischen Betriebsspannung von 1,7 V um etwa 7 Größenordnungen reduziert werden.

Vorzugsweise ist die Dotierungsdichte *N*_{D} der Stromblende (d. h. der dotierten Schicht bzw. Schichten der Stromblende) größer oder gleich 1/10 (*N*_{D} ≥ 0,1·*N*_{A}), bevorzugter größer oder gleich 1/2 (*N*_{D} ≥ 0,5·*N*_{A}), der Dotierungsdichte *N*_{A} einer die Stromblende umgebenden Schicht. Besonders bevorzugt stimmen die beiden Dotierungsdichten in etwa überein (*N*_{D} ≈ *N*_{A})*.* Beispielsweise liegen bei einer Anordnung der Stromblende innerhalb der p-Kontaktschicht reale Dotierungsdichten *N*_{D} für die beiden Sperrschichten bevorzugt zwischen 0,2·10¹⁸ cm⁻³ und 2·10¹⁸ cm⁻³, bevorzugter zwischen 0,5·10¹⁸ cm⁻³ und 1,5·10¹⁸ cm⁻³ und besonderes bevorzugt bei etwa 1·10¹⁸ cm⁻³. Bei einer vergleichbaren herkömmlichen Stromblende mit einer auf den genannten Sperrschichten basierenden "p-n-p"-Struktur müssen die Dotierungsdichten *N*_{D} mit etwa 2·10¹⁸ cm⁻³ für eine vergleichbare Durchschlagsspannung im Allgemeinen deutlich höher liegen.

Vorzugsweise ist die unbeabsichtigte Dotierungsdichte *n*ᵢ einer intrinsischen Außenschicht kleiner oder gleich ein 1/10 (*n*ᵢ ≤ 0,1·*N*_{D}), bevorzugter kleiner oder gleich 1/2 (*n*ᵢ ≤ 0,5·*N*_{D}) der Dotierungsdichte *N*_{D} der Stromblende. Besonders bevorzugt ist die unbeabsichtigte Dotierungsdichte *n*ᵢ ≤ 1·10¹⁶ cm⁻³. Die unbeabsichtigte Dotierung einer intrinsischen Außenschicht kann entweder eine n- oder p-Dotierung sein.

Die Integration von dünnen intrinsischen Schichten an den p-n-Übergängen von Stromblenden, die insbesondere eine "p-i-n-i-p"- bzw. eine "n-i-p-i-n"-Struktur erzeugen, führt zu breiteren Verarmungsbereichen und damit zu einer geringeren Tunnelwahrscheinlichkeit. Sie ermöglicht eine geringere Dotierung in den eigentlichen Sperrschichten der Stromblende, was bei einer gleichbleibend guten Sperrwirkung die Verarmungsbereichen weiter verbreitet. Durch verbreiterte Verarmungszonen wird zudem die Tunnelwahrscheinlichkeit verringert und daher die Durchschlagsspannung erhöht.

Durch die geringere Tunnelwahrscheinlichkeit insbesondere bei einer "p-i-n-i-p"- bzw. eine "n-i-p-i-n"-Struktur ist die Wirksamkeit der Blockierung auch bei hohen Leistungen und Temperaturen gewährleistet. Daher kann es sich bei einem erfindungsgemäßen Diodenlaser bevorzugt um einen Hochleistungs-Breitstreifen-Diodenlaser handeln.

Weitere bevorzugte Ausgestaltungen der Erfindung ergeben sich aus den in den Unteransprüchen genannten Merkmalen.

Die verschiedenen in dieser Anmeldung genannten Ausführungsformen der Erfindung sind, sofern im Einzelfall nicht anders ausgeführt, mit Vorteil miteinander kombinierbar.

### Kurzbeschreibung der Zeichnungen

Die Erfindung wird nachfolgend in Ausführungsbeispielen anhand der zugehörigen Zeichnung erläutert. Es zeigen:
- Fig. 1: eine schematische Darstellung einer exemplarischen herkömmlichen Laserdiode mit einer Stromblende mit "p-n-p"-Struktur,
- Fig. 2: eine schematische Darstellung einer ersten Ausführungsform einer erfindungsgemäßen Laserdiode mit einer Stromblende mit "p-i-n-i-p"-Struktur,
- Fig. 3: eine schematische Darstellung einer zweiten Ausführungsform einer erfindungsgemäßen Laserdiode mit einer Stromblende mit "p-i-n-i-p"-Struktur,
- Fig. 4: eine schematische Darstellung einer dritten Ausführungsform einer erfindungsgemäßen Laserdiode mit einer Stromblende mit "n-i-p-i-n"-Struktur,
- Fig. 5: einen berechneten Bandverlauf innerhalb einer Stromblende bei einer a) herkömmlichen Laserdiode nach FIG. 1 und b) einer Ausführungsform einer erfindungsgemäßen Laserdiode mit einer Stromblende mit "p-i-n-i-p"-Struktur nach FIG. 2,
- Fig. 6: Simulationen zur U-I-Kennlinien herkömmlicher Laserdioden mit und ohne Stromblende sowie einer erfindungsgemäßen Laserdiode, und
- Fig. 7: gemessene U-I-Kennlinien herkömmlicher Laserdioden mit und ohne Stromblende sowie einer erfindungsgemäßen Laserdiode.
- Fig. 8: eine Berechnung zur Tunnelstromdichte *J*ₜ bei unterschiedlichen Dicken *d*ᵢ der intrinsischen Außenschichten und verschiedenen Spannungen *U.*

### Ausführliche Beschreibung der Zeichnungen

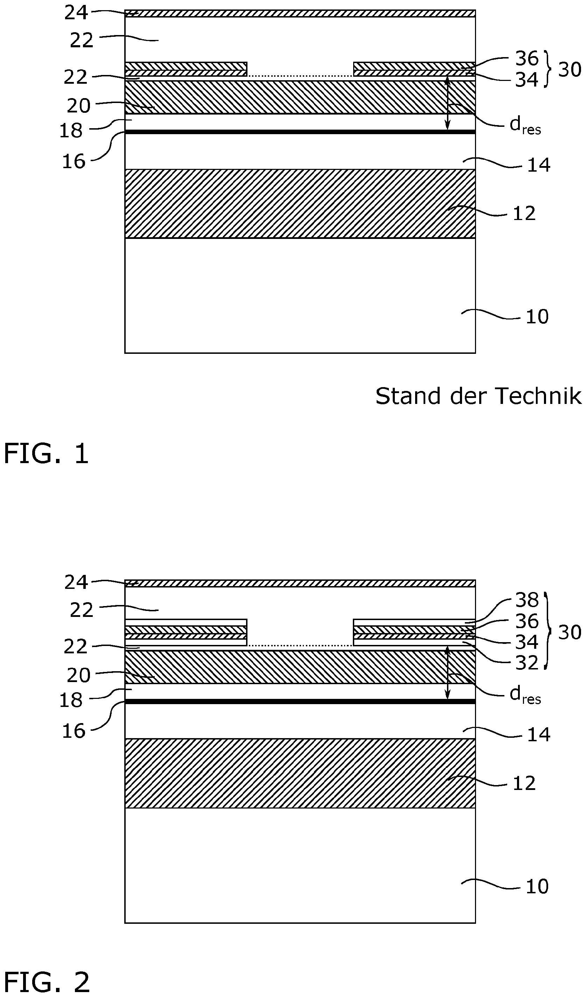

Figur 1 zeigt eine schematische Darstellung einer exemplarischen herkömmlichen Laserdiode mit einer Stromblende mit "p-n-p"-Struktur. Die gezeigte Laserdiode umfasst dabei ein n-Substrat 10, eine auf dem n-Substrat 10 aufliegende n-Mantelschicht 12, eine auf der n-Mantelschicht 12 aufliegende n-Wellenleiterschicht 14, eine auf der n-Wellenleiterschicht 14 aufliegende aktive Schicht 16, eine auf der aktiven Schicht 16 aufliegenden p-Wellenleiterschicht 18, eine auf der p-Wellenleiterschicht 18 aufliegende p-Mantelschicht 20, eine im zentralen Bereich der Laserdiode auf der p-Mantelschicht 20 aufliegende p-Kontaktschicht 22, und einen auf der p-Kontaktschicht 22 aufliegenden metallischen p-Kontakt 24. Die aus einem n-dotierten Material bestehende Stromblende 30 ist innerhalb der p-Kontaktschicht 22 angeordnet, d. h. die Stromblende 30 wird von der p-Kontaktschicht 22 nach oben und nach unten begrenzt. Die gezeigte Stromblende 30 umfasst eine dünnere erste Schicht 34 und eine auf der ersten Schicht 34 aufliegende dickere zweite Schicht 36. Die Stromblende 30 der Laserdiode weist somit eine "p-n-p"-Struktur auf.

Figur 2 zeigt eine schematische Darstellung einer ersten Ausführungsform einer erfindungsgemäßen Laserdiode mit einer Stromblende mit "p-i-n-i-p"-Struktur. Der grundlegende Schichtaufbau der Laserdiode entspricht weitgehend der in FIG. 1 gezeigten Darstellung. Die jeweiligen Bezugszeichen und deren Zuordnung zu den einzelnen Merkmalen gelten daher entsprechend. Im Gegensatz zu der in FIG. 1 gezeigten Laserdiode wird die Stromblende 30 erfindungsgemäß an der Unterseite von einer ersten intrinsischen Außenschicht 32 und an der Oberseite von einer zweiten intrinsischen Außenschicht 38 begrenzt. Die Stromblende 30 der Laserdiode weist somit eine erfindungsgemäße "p-i-n-i-p"-Struktur auf. Der vertikale Abstand *d*ᵣₑₛ zwischen der aktiven Schicht 16 und der Stromblende 30 ist dabei größer als der Abstand zwischen der aktiven Schicht 16 und der Unterseite der p-Kontaktschicht 22, aber kleiner als der Abstand zwischen der aktiven Schicht 16 und der Unterseite des p-Kontakts 24. Die Stromblende ist somit vollständig innerhalb der p-Kontaktschicht 22 angeordnet.

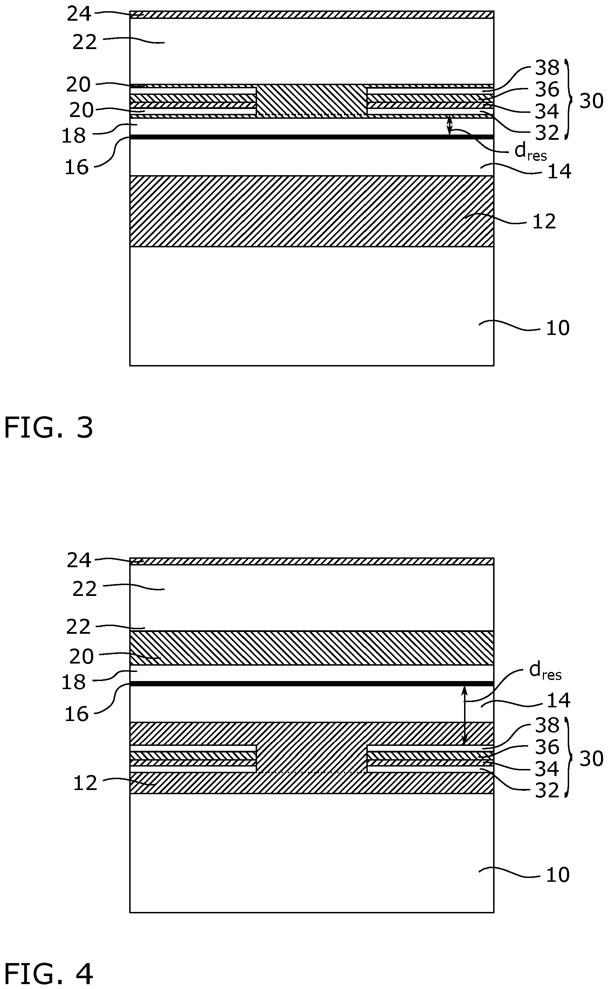

Figur 3 zeigt eine schematische Darstellung einer zweiten Ausführungsform einer erfindungsgemäßen Laserdiode mit einer Stromblende mit "p-i-n-i-p"-Struktur. Der grundlegende Schichtaufbau der Laserdiode entspricht weitgehend der in FIG. 2 gezeigten Darstellung. Die jeweiligen Bezugszeichen und deren Zuordnung zu den einzelnen Merkmalen gelten daher entsprechend. Im Gegensatz zu der in FIG. 2 gezeigten Laserdiode ist die Stromblende 30 hierbei statt in der p-Kontaktschicht 22 vollständig innerhalb der p-Mantelschicht 20 angeordnet. Der vertikale Abstand *d*ᵣₑₛ zwischen der aktiven Schicht 16 und der Stromblende 30 ist daher größer als der Abstand zwischen der aktiven Schicht 16 und der Unterseite der p-Mantelschicht 20, aber kleiner als der Abstand zwischen der aktiven Schicht 16 und der Unterseite der p-Kontaktschicht 22.

Figur 4 zeigt eine schematische Darstellung einer dritten Ausführungsform einer erfindungsgemäßen Laserdiode mit einer Stromblende mit "n-i-p-i-n"-Struktur. Der grundlegende Schichtaufbau der Laserdiode entspricht weitgehend der in FIG. 2 gezeigten Darstellung. Die jeweiligen Bezugszeichen und deren Zuordnung zu den einzelnen Merkmalen gelten daher entsprechend. Im Gegensatz zu der in FIG. 2 gezeigten Laserdiode ist die Stromblende 30 hierbei statt in der Kontaktschicht 22 vollständig innerhalb der n-Mantelschicht 12 angeordnet. Entsprechend der entgegengegengesetzten Dotierung der n-Mantelschicht 12 muss die Stromblende 30 hierbei jedoch aus einem p-dotierten Material aufgebaut sein. Die gezeigte Stromblende 30 umfasst eine dünnere erste Schicht 34 und eine auf der ersten Schicht 34 aufliegende dickere zweite Schicht 36. Die Stromblende 30 wird erfindungsgemäß an der Unterseite von einer ersten intrinsischen Außenschicht 32 und an der Oberseite von einer zweiten intrinsischen Außenschicht 38 begrenzt. Die Stromblende 30 der Laserdiode weist somit eine erfindungsgemäße "n-i-p-i-n"-Struktur auf.

Der Betrag des vertikalen Abstands *d*ᵣₑₛ zwischen der aktiven Schicht 16 und der Stromblende 30 ist daher größer als der Abstand zwischen der aktiven Schicht 16 und der Oberseite der n-Mantelschicht 14, aber kleiner als der Abstand zwischen der aktiven Schicht 16 und der Oberseite des n-Substrats 10.

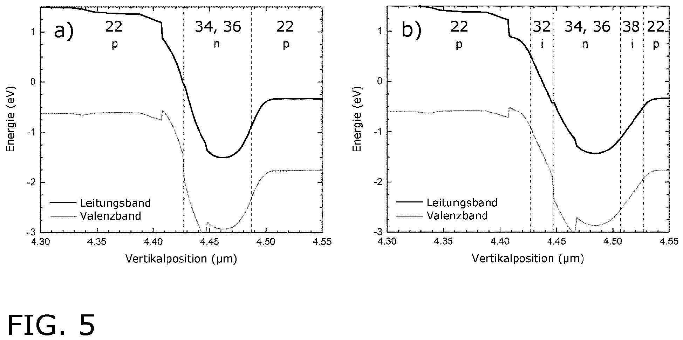

Figur 5 zeigt einen berechneten Bandverlauf innerhalb einer Stromblende bei einer a) herkömmlichen Laserdiode nach FIG. 1 und b) einer Ausführungsform einer erfindungsgemäßen Laserdiode mit einer Stromblende mit "p-i-n-i-p"-Struktur nach FIG. 2. In den in a) gezeigten Bandverlauf ist die "p-n-p"-Struktur mit einer Schichtfolge entsprechend einer p-Kontaktschicht 22, der Stromblende 30 mit einer ersten Schicht 34 und einer zweiten Schicht 36, sowie der p-Kontaktschicht 22 eingezeichnet. In dem in b) gezeigten Bandverlauf sind zusätzlich erfindungsgemäß zwischen den einzelnen p-n-Übergängen eine erste intrinsische Außenschicht 32 sowie eine zweite intrinsische Außenschicht 38 angeordnet. Es ist den gezeigten Bandverläufen zu entnehmen, dass mit der "p-i-n-i-p"-Struktur die wirksame Breite der Stromblende deutlich erhöht werden kann, wobei der allgemeine Verlauf der Bandstruktur jedoch weitgehend erhalten bleibt.

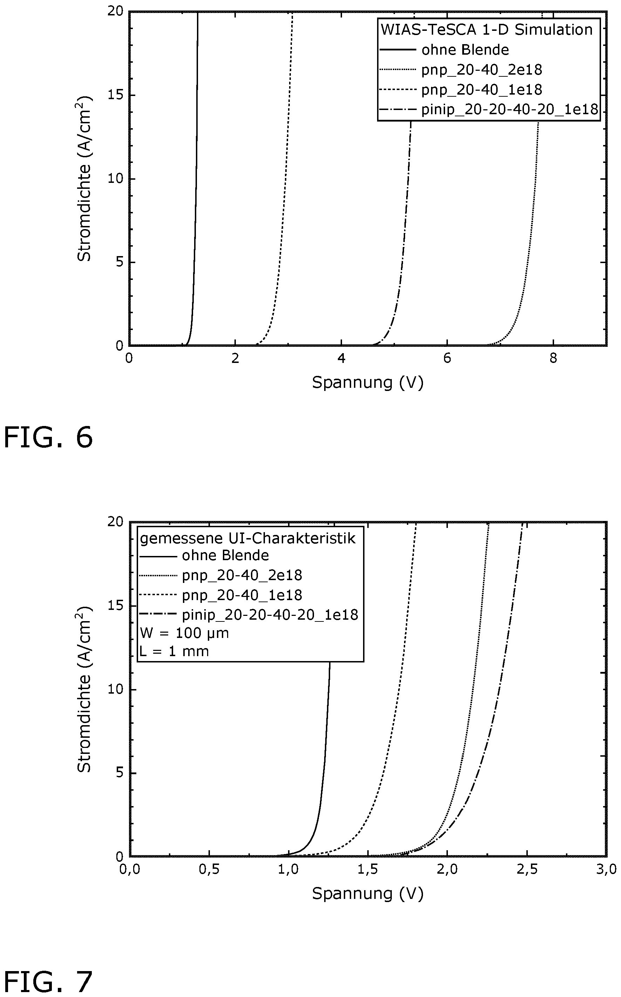

Figur 6 zeigt Simulationen zur U-I-Kennlinien herkömmlicher Laserdioden mit und ohne Stromblende sowie einer erfindungsgemäßen Laserdiode. Für die Simulationen (WIAS-TeSCA 1-D Simulation) wurde eine Laserdiode mit einer Stromblende mit "p-n-p"-Struktur gemäß FIG. 1 als Basis angenommen. Bei dem Material der Kontaktschicht handelte es sich um p⁺-GaAs. Die erste Schicht der Stromblende aus n-In_{0.48}Ga_{0.52}P wies in der Simulation eine Dicke von 20 nm auf, während die zweite Schicht der Stromblende aus n-GaAs eine Dicke von 40 nm aufwies. Für beide Sperrschichten wurden einheitliche Dotierungsdichten *N*_{D} von 1·10¹⁸ cm⁻³ bzw. 2·10¹⁸ cm⁻³ vorgegeben. Die herkömmliche Laserdiode ohne Stromblende (Kurve "ohne Blende") entsprach in der Simulation bis auf die fehlende "p-n-p"-Struktur den mit der herkömmlichen Stromblende simulierten Diodenlasern. Für einen erfindungsgemäßen Diodenlaser wurde die oben beschriebene "p-n-p"-Struktur derart abgeändert, dass die Stromblende eine "p-i-n-i-p"-Struktur aufweist, wobei die Dicke der intrinsischen Schichten jeweils 20 nm betrug. Für die entsprechenden Sperrschichten wurde eine einheitliche Dotierungsdichte *N*_{D} von 1·10¹⁸ cm⁻³ vorgegeben. Die Simulationen berücksichtigten nicht das Auftreten von Tunneleffekten.

Für eine "p-n-p"-Struktur sagen die Simulationen eine Reduzierung der Durchschlagsspannung von etwa 7,2 V auf etwa 2,7 V voraus, wenn die Dotierungsdichte *N*_{D} der n-dotierten Sperrschichten von 2·10¹⁸ cm⁻³ auf 1·10¹⁸ cm⁻³ reduziert wird (Kurven "pnp_20-40_1e18" und "pnp_20-40_2e18"). Die Blockierfähigkeit der "p-i-n-i-p"-Struktur (*N*_{D} = 1·10¹⁸ cm⁻³, Kurve "pinip_20-20-40-20_1e18") soll nach den Simulationen mit einer Durchschlagsspannung von etwa 5,0 V zwischen diesen beiden Werten liegen.

Figur 7 zeigt gemessene U-I-Kennlinien herkömmlicher Laserdioden mit und ohne Stromblende sowie einer erfindungsgemäßen Laserdiode. Insbesondere handelt es sich um Messungen an einer Laserdioden-Teststruktur mit komplett uniformer Stromblende (wenig Strom soll fließen) und einer herkömmlichen Laserdiode ohne Stromblende (Referenzwerte) sowie einer erfindungsgemäßen Laserdioden-Teststruktur. Die vermessenen Laserdioden und Laserdiode-Teststrukturen entsprechen den voranstehend zur FIG. 6 beschriebenen Parametern für die Simulationen, daher erfolgt die Zuordnung zu den einzelnen Kurven entsprechend. Die Streifenbreite der Laserdioden war jeweils 100 µm bei einer effektiven Resonatorlänge von 1 mm.

Bei allen Strukturen ist die gemessene Durchschlagsspannung erheblich niedriger als aus den TeSCA-Simulationen (FIG. 6) erwartet. Dies ist darauf zurückzuführen, dass mit TeSCA eine ideale Struktur simuliert wird, wobei Abweichungen vom idealen Verhalten (z. B. Diffusion von In-Atomen oder Si-Dotierstoffatomen) oder verschiedene elektrische Effekte (z. B. Tunnelbildung, Lawinenbildung, ...) nicht berücksichtigt werden. Im Vergleich zu anderen Strukturen bietet eine erfindungsgemäße "p-i-n-i-p"-Struktur jedoch einen klaren Vorteil. Die Simulationen sagen voraus, dass die Durchschlagsspannung zwischen den "p-n-p"-Strukturen mit hoher und niedriger Dotierungsdichte *N*_{D} liegen sollte, während die Messungen zeigen, dass sie trotz der niedrigen Dotierungsdichte der n-dotierten Sperrschichten tatsächlich die höchste Blockierfähigkeit aufweist. Dies ist insbesondere auf eine erhebliche Reduzierung von Tunnelströmen und somit der Tunnelwahrscheinlichkeit zurückzuführen.

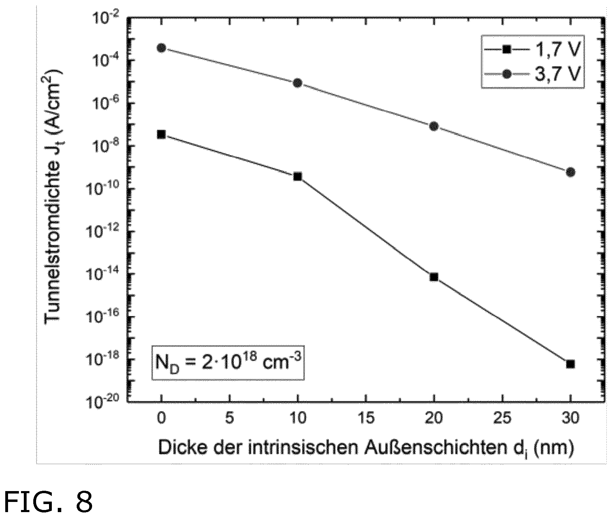

Figur 8 zeigt eine Berechnung zur Tunnelstromdichte *J*ₜ bei unterschiedlichen Dicken *d*ᵢ der intrinsischen Außenschichten und verschiedenen Spannungen *U.* Die Berechnung basiert auf simulierten Bandverläufe und nach dem Berechnungsmodell aus Y. Taur und T. H. Ning, Fundamentals of Modern VLSI Devices, 2nd ed., Cambridge University Press (2009). Bei einer typischen Betriebsspannung von 1,7 V wird die Tunnelstromdichte *J*ₜ bei einer Dicke *d*ᵢ der intrinsischen Außenschichten von 5 nm um 1 Größenordnung reduziert. Bei einer bevorzugten Dicke von 10 nm wird die Tunnelstromdichte *J*ₜ um 2 Größenordnungen, bei einer am meisten bevorzugten Dicke von 20 nm um 7 Größenordnungen, und bei einer ebenfalls bevorzugten Dicke von 30 nm um 11 Größenordnungen reduziert. Die Berechnung zeigen auch, dass eine Erhöhung der Spannung (z. B. auf 3,7 V) zu einer Erhöhung der Tunnelstromdichte *J*ₜ führt.

### Bezugszeichenliste

- 10: n-Substrat
- 12: n-Mantelschicht
- 14: n-Wellenleiterschicht
- 16: aktive Schicht
- 18: p-Wellenleiterschicht
- 20: p-Mantelschicht
- 22: p-Kontaktschicht
- 24: p-Kontakt

- 30: Stromblende
- 32: erste intrinsische Außenschicht (Stromblende)
- 34: erste Schicht (Stromblende)
- 36: zweite Schicht (Stromblende)
- 38: zweite intrinsische Außenschicht (Stromblende)

## Patentansprüche

1. Diodenlaser, umfassend:
ein n-Substrat (10) aus einem n-dotierten Material;
eine auf dem n-Substrat (10) angeordnete n-Mantelschicht (12) aus einem n-dotierten Material;
eine auf der n-Mantelschicht (12) angeordnete n-Wellenleiterschicht (14) aus einem n-dotierten Material;
eine auf der n-Wellenleiterschicht (14) angeordnete aktive Schicht (16);
eine auf der aktiven Schicht (16) angeordnete p-Wellenleiterschicht (18) aus einem p-dotierten Material;
eine auf der p-Wellenleiterschicht (18) angeordnete p-Mantelschicht (20) aus einem p-dotierten Material;
eine auf der p-Mantelschicht (20) angeordnete p-Kontaktschicht (22) aus einem p-dotierten Material; und
einen auf der p-Kontaktschicht (22) angeordneten p-Kontakt (24);
wobei der Diodenlaser durch eine schichtförmig ausgebildete Stromblende (30) aus einem entgegen seiner Umgebung dotierten Material für eine räumlich selektive Bestromung der aktiven Schicht (16) zwischen dem n-Substrat (10) und dem p-Kontakt (24) ausgebildet ist;
wobei die Stromblende (30) über eine intrinsische Außenschicht (32, 38) von angrenzenden Schichten getrennt ist, **dadurch gekennzeichnet, dass**
die Dicke der intrinsischen Außenschicht (32, 38) zwischen 5 nm und 50 nm liegt, wobei die Stromblende (30) eine erste Schicht (34) aus dotiertem InGaP, und eine zweite Schicht (36) aus dotiertem GaAs umfasst, wobei die Dicke der zweiten Schicht (36) größer als die Dicke der ersten Schicht (34) ist und die Summe der Dicken der ersten Schicht (34) und der zweiten Schicht (36) zwischen 5 nm und 100 nm liegt.

2. Diodenlaser nach Anspruch 1, wobei die Stromblende (30) eine obere intrinsische Außenschicht (32) und/oder eine untere intrinsische Außenschicht (38) aufweist.

3. Diodenlaser nach Anspruch 1 oder 2, wobei die Stromblende (30) innerhalb der p-Kontaktschicht (22), innerhalb der p-Mantelschicht (20) oder innerhalb der n-Mantelschicht (12) angeordnet ist.

4. Diodenlaser nach einem der vorhergehenden Ansprüche, wobei der Betrag des vertikalen Abstands *d*ᵣₑₛ der Stromblende (30) von der aktiven Schicht (16) kleiner als 1,5 µm beträgt.

5. Diodenlaser nach Anspruch 5, wobei die erste Schicht (34) aus dotiertem In_{0.48}Ga_{0.52}P ausgebildet ist.

6. Diodenlaser nach einem der vorhergehenden Ansprüche, wobei das Verhältnis der Dicke der ersten Schicht (34) zur Dicke der zweiten Schicht (36) zwischen 0,2 und 1,0 liegt.

7. Diodenlaser nach einem der vorhergehenden Ansprüche, wobei die Dotierungsdichte *N*_{D} der Stromblende (30) größer oder gleich 1/10 der Dotierungsdichte *N*_{A} einer die Stromblende (30) umgebenden Schicht ist.

## Claims

1. A diode laser, comprising:
an n-substrate (10) of an n-doped material;
an n-cladding layer (12) of an n-doped material arranged on the n-substrate (10);
an n-waveguide layer (14) of an n-doped material arranged on the n-cladding layer (12);
an active layer (16) arranged on the n-waveguide layer (14);
a p-waveguide layer (18) of a p-doped material arranged on the active layer (16);
a p-cladding layer (20) of an p-doped material arranged on the p-waveguide layer (18); a p-contact layer (22) of a p-doped material arranged on the p-cladding layer (20); and a p-contact (24) arranged on the p-contact layer (22);
wherein the diode laser is formed, through a current shade (30) formed to be layered,
from a doped material opposing its surroundings for a spatially selective current supply to the active layer (16) between the n-substrate (10) and the p-contact (24);
wherein the current shade (30) is separated from adjacent layers via an intrinsic external layer (32, 38), **characterized in that** the thickness of the intrinsic external layer (32, 38) is between 5 nm and 50 nm, wherein the current shade (30) comprises a first layer (34) of doped InGaP and a second layer (36) of doped GaAs, wherein the thickness of the second layer (36) is greater than the thickness of the first layer (34) and the sum of the thicknesses of the first layer (34) and the second layer (36) is between 5 nm and 100 nm.

2. The diode laser according to Claim 1, wherein the current shade (30) has an upper intrinsic external layer (32) and/or a lower intrinsic external layer (38).

3. The diode laser according to Claim 1 or 2, wherein the current shade (30) is arranged within the p-contact layer (22), within the p-cladding layer (20) or within the n-cladding layer (12).

4. The diode laser according to any one of the preceding claims, wherein the value of the vertical distance *d*ᵣₑₛ of the current shade (30) from the active layer (16) is smaller than 1.5 µm.

5. The diode laser according to Claim 5, wherein the first layer (34) is formed from doped In_{0.48}Ga_{0.52}P.

6. The diode laser according to any one of the preceding claims, wherein the ratio of the thickness of the first layer (34) to the thickness of the second layer (36) is between 0.2 and 1.0.

7. The diode laser according to any one of the preceding claims, wherein the doping density ND of the current shade (30) is greater or equal to 1/10 of the doping density *N*_{A} of a layer surrounding the current shade (30).

## Revendications

1. Laser à diode, comprenant :
un substrat n (10) d'un matériau dopé n ;
une couche de revêtement n (12) d'un matériau dopé n disposée sur le substrat n (10) ; une couche guide d'ondes n (14) d'un matériau dopé n disposée sur la couche de revêtement n (12) ;
une couche active (16) disposée sur la couche guide d'ondes n (14) ;
une couche guide d'ondes p (18) d'un matériau dopé p disposée sur la couche active (16) ;
une couche de revêtement p (20) d'un matériau dopé p disposée sur la couche guide d'ondes p (18) ;
une couche de contact p (22) d'un matériau dopé p disposée sur la couche de revêtement p (20) ; et
un contact p (24) disposé sur la couche contact p (22) ;
le laser à diode étant formé entre le substrat n (10) et le contact p (24) par une protection contre le courant (30) conçue en forme de couche, d'un matériau dopé de façon opposée à son environnement pour une alimentation électrique de la couche active (16) spatialement sélective ;
la protection contre le courant (30) étant séparée des couches adjacentes par une couche extérieure intrinsèque (32, 38), **caractérisé en ce que** l'épaisseur de la couche extérieure intrinsèque (32, 38) se situe entre 5 nm et 50 nm, la protection contre le courant (30) comprenant une première couche (34) en InGaP dopé, et une deuxième couche (36) en GaAs dopé, l'épaisseur de la deuxième couche (36) étant supérieure à l'épaisseur de la première couche (34) et la somme des épaisseurs de la première couche (34) et de la deuxième couche (36) étant située entre 5 nm et 100 nm.

2. Laser à diode selon la revendication 1, la protection contre le courant (30) présentant une couche extérieure intrinsèque supérieure (32) et/ou une couche extérieure intrinsèque inférieure (38).

3. Laser à diode selon la revendication 1 ou 2, la protection contre le courant (30) étant disposée à l'intérieur de la
couche contact p (22), à l'intérieur de la couche de revêtement p (20) ou à l'intérieur de la couche de revêtement n (12).

4. Laser à laser selon l'une quelconque des revendications précédentes, la valeur de la distance verticale *d*ᵣₑₛ entre la protection contre le courant (30) et la couche active (16) étant inférieure à 1,5 µm.

5. Laser à diode selon la revendication 5, la première couche (34) étant formée en In_{0,48}Ga_{0,52}P dopé.

6. Laser à diode selon l'une quelconque des revendications précédentes, le rapport entre l'épaisseur de la première couche (34) et l'épaisseur de la deuxième couche (36) étant situé entre 0,2 et 1,0.

7. Laser à diode selon l'une quelconque des revendications précédentes, l'épaisseur de dopage *N_{D}* de la protection contre le courant (30) étant supérieure ou égale à 1/10 de l'épaisseur de dopage *N*_{A} d'une couche entourant la protection contre le courant (30).
